Europäisches Patentamt

European Patent Office

Office européen des brevets

(19)

(11) Numéro de publication : **0 209 717 B1**

(12) **FASCICULE DE BREVET EUROPÉEN**

(45) Date de publication du fascicule du brevet : **17.05.89**

(51) Int. Cl.⁴ : **G 04 C 10/00**

(21) Numéro de dépôt : **86108166.9**

(22) Date de dépôt : **14.06.86**

(54) **Logement de pile pour montre électronique.**

(30) Priorité : **25.06.85 CH 2708/85**

(43) Date de publication de la demande : **28.01.87 Bulletin 87/05**

(45) Mention de la délivrance du brevet : **17.05.89 Bulletin 89/20**

(84) Etats contractants désignés : **DE FR GB**

(56) Documents cités :
EP—A— 0 024 364
CH—A— 632 895
CH—B— 634 195
GB—A— 1 566 695
GB—A— 2 020 861
GB—A— 2 112 562
US—A— 4 165 607
US—A— 4 201 040
US—A— 4 223 521

(73) Titulaire : **Eta SA Fabriques d'Ebauches Schild-Rust-Strasse 17 CH-2540 Granges (CH)**

(72) Inventeur : **Morata, Philippe 14, Crêt du Haut CH-2502 Bienne (CH)**

(74) Mandataire : **de Raemy, Jacques et al ICB Ingénieurs Conseils en Brevets SA Passage Max. Meuron 6 CH-2001 Neuchâtel (CH)**

EP 0 209 717 B1

Jouve, 18, rue St-Denis, 75001 Paris, France

## Description

La présente invention est relative à un logement de pile pour montre électronique du type comportant une platine située entre un fond et un cadran, un circuit imprimé comprenant un substrat et au moins une piste conductrice, ledit logement comportant un trou traversant de part en part ladite platine, le bord du trou situé du côté cadran étant muni d'un rebord faisant saillie dans le trou.

Un tel logement de pile est connu du brevet CH-A-632 895 (= US-A-4,430,009). Dans cette construction la pile est maintenue à la platine par une bride vissée à ses extrémités et située du côté fond de la montre. On entrepose entre l'électrode de la pile et la bride un circuit imprimé qui comporte une piste conductrice en contact avec l'électrode. La pile est logée dans un trou qui traverse de part en part la platine, le bord de ce trou côté cadran étant muni d'un rebord en forme de biseau faisant saillie dans le trou. Dans cette disposition le bord de la pile repose sur le rebord en forme de biseau.

Un tel arrangement permet de réduire l'encombrement pris en hauteur par le logement de la pile et présente un avantage sur ce qui est proposé par exemple dans le brevet GB-A-1 408 610. Dans ce dernier document en effet, la pile est logée dans un trou pratiqué dans la platine, le fond du trou étant constitué par une paroi faisant partie de cette platine. Or on sait que pour être réalisable pratiquement ce fond doit avoir une épaisseur d'au moins 0,15 à 0,20 mm. Il en résulte un encombrement prohibitif dans le sens de l'épaisseur de la montre, particulièrement s'il s'agit des montres dites extra-plates.

Le premier document cité ci-dessus présente cependant plusieurs inconvénients. Tout d'abord la construction proposée est mal adaptée aux tolérances extrêmes qu'on trouve sur le diamètre de la pile. Si ce diamètre est petit il y a risque pour la pile de ne pas reposer sur le rebord biseauté, mais directement sur le cadran de la montre. Ensuite si la pile est introduite à l'envers, il y a de fortes chances que son électrode vienne toucher le cadran créant ainsi avec la platine un court-circuit aux bornes de la pile. Enfin la bride proposée, fixée au moyen de deux vis à la platine, ne permet pas d'absorber les grandes différences qu'on rencontre dans l'épaisseur même des piles susceptibles d'être utilisées.

L'arrangement présenté dans le document GB-A-1 566 695 poursuit la même intention de diminuer au mieux l'encombrement du logement de pile dans le sens de l'épaisseur de la montre. Pour cela, le logement de pile comporte aussi un trou qui traverse de part en part la platine, ce trou étant obturé par un couvercle fait en matière isolante. Ce couvercle est cependant plus épais que s'il était fait en métal et surtout déborde le logement dans une saignée annulaire où il est fixé au moyen de deux tétons taraudés. Cette construction utilise une place importante dans le sens du diamètre de la pile et est plus chère et plus compliquée à mettre en œuvre que celle de la présente invention. Cette construction nécessite également une languette d'appui qui est indépendante du couvercle puisque ce couvercle n'est pas réalisé en matériau élastique. On verra que dans la présente invention, cette languette d'appui est directement sortie du couvercle, ce qui simplifie la construction et ce qui permet d'amener le circuit imprimé souple directement entre la languette et un pôle de la pile sans devoir passer par une connexion à vis comme c'est le cas dans le document cité.

La présente invention permet, tout en respectant les mêmes conditions de faible encombrement en hauteur, d'obvier aux inconvénients cités. Pour ce faire elle met en œuvre les moyens qui apparaissent dans les revendications.

L'invention sera comprise maintenant à l'aide de la description qui suit et du dessin qui l'illustre à titre d'exemple et dans lequel :

la figure 1 est une vue de dessus du logement de pile selon l'invention et

la figure 2 est une coupe selon la ligne II-II de la figure 1.

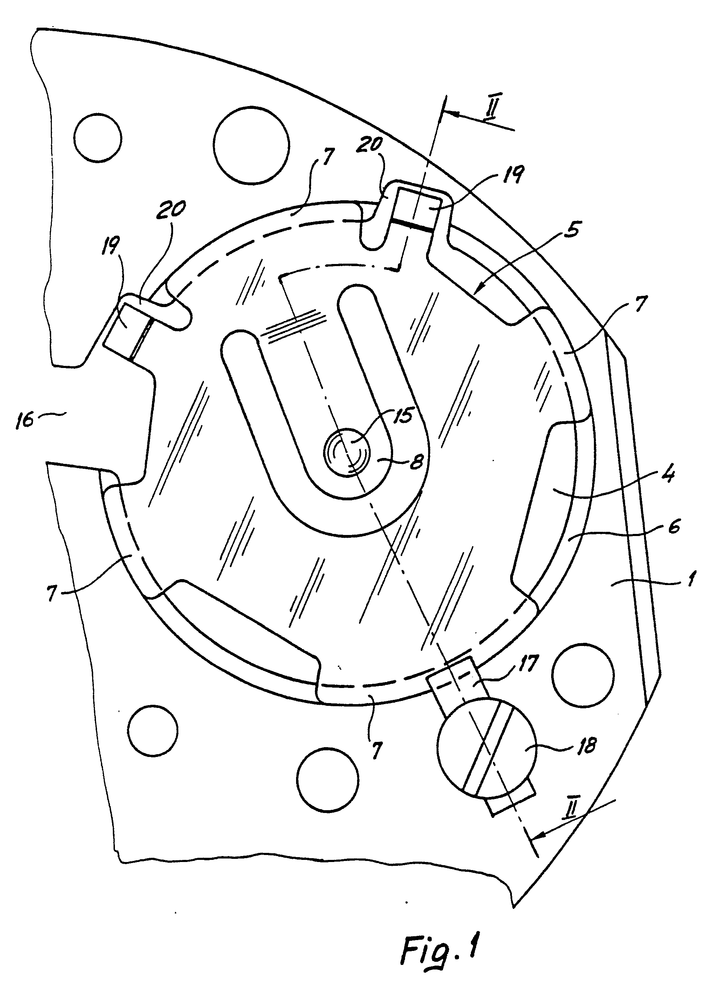

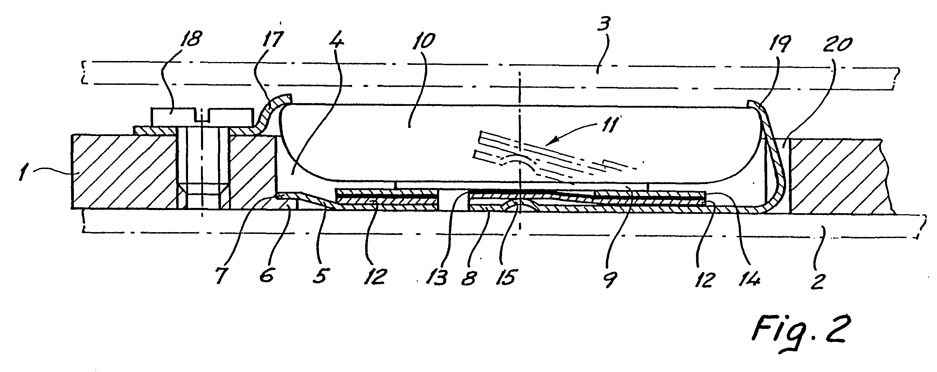

Les figures 1 et 2 présentent un premier mode d'exécution du logement de pile selon l'invention. La montre qui y est représentée partiellement comprend une platine 1 située entre un cadran 2 et un fond 3. On pratique dans la platine 1 un trou 4 la traversant de part en part. Le diamètre de ce trou est légèrement supérieur au diamètre maximum de la pile qu'on désire y loger. Selon l'invention le bord du trou situé côté cadran est muni d'un rebord 6 faisant saillie dans le trou. Ce rebord sert d'appui à un couvercle 5 qui est introduit dans le trou du côté fond 3. Le couvercle peut appuyer sur ledit rebord sur toute sa circonférence mais peut aussi, comme le montre la figure 1 n'y reposer qu'en certains endroits référencés 7. Pour gagner de la place en hauteur, les plages d'appui 7 sont relevées par rapport au couvercle proprement dit ce qui fait que l'épaisseur du couvercle 5 est comprise dans l'épaisseur du rebord 6.

Selon une caractéristique importante de l'invention, une languette 8 est levée dans le couvercle 5. Cette languette appuie sur une face 9 d'une pile 10 quand ladite pile est introduite dans le logement. La pile est ainsi sollicitée vers le haut retenue qu'elle est par des brides dont il sera question plus loin et par le fond 3 de la montre. La face 9 de la pile est l'électrode opposée à l'électrode de masse, cette dernière étant en contact élastique avec la platine, les brides et le fond.

Comme on le voit en figure 2, un circuit imprimé 11 comprenant un substrat isolant 12 et au moins une piste conductrice 13 est intercalé entre la languette 8 et la pile 10. La piste conductrice est recouverte encore d'une couche isolante 14 qui empêche ladite piste de venir en contact avec l'électrode de masse de la pile. Les matériaux utilisés pour réaliser le circuit imprimé sont de très faible épaisseur. On pourra utiliser pour le substrat une feuille isolante portant la marque déposée « Kapton » et pour la couche de protection une feuille du type « Ryston » (marque déposée). Dans cette construction la piste conductrice (généralement du cuivre doré) est mise à nu à l'extrémité de la languette 8, c'est-à-dire à l'endroit où se présente le centre de l'électrode 9 de la pile 10. Pour améliorer le contact électrique, la figure 2 montre qu'on a levé une goutte 15 dans la languette 8 ce qui permet d'assurer un contact très ponctuel de la piste conductrice 13 sur l'électrode 9 de la pile. La languette 8 et le circuit imprimé 11 ont été représentés sur la figure 2 en traits pleins dans le cas ou la pile est présente dans son logement et en traits mixtes dans le cas où cette pile est enlevée. Les épaisseurs des couches composant le circuit imprimé ont été fortement amplifiées pour faciliter la lecture de la figure.

Pour ne pas embarrasser la figure 1 de détails qui ne sont pas nécessaires à la compréhension de l'invention, on a évité de représenter la pile 10 et le circuit imprimé 11. Cette vue de dessus montre le logement de pile formé du trou 4 pratiqué dans la platine 1 et du couvercle 5 mis en place au fond du trou. La figure 1 montre un canal 16 creusé dans la platine et débouchant dans le trou 4. Le circuit imprimé assurant le contact avec la pile est relié aux autres éléments électriques de la montre par un isthme passant par ce canal 16. On retrouve ici une construction analogue à ce qui faisait l'objet du brevet CH-A-632 895 (=US 4,430,009) cité plus haut et auquel on se référera pour avoir plus de détails sur cette partie constructive.

Comme on le voit encore sur les figures 1 et 2, la pile, une fois introduite dans son logement, est retenue dans le sens de la hauteur par un étrier 17 fixé sur la platine 1 au moyen d'une vis 18. Selon un mode d'exécution propre à la présente invention, la pile est également retenue latéralement dans son logement par deux brides supplémentaires 19 qui font partie intégrante du couvercle et qui remontent le trou dans sa périphérie. Pour permettre à ces brides de jouer élastiquement, la platine présente des dégagements 20 dans lesquels lesdites brides sont logées. Les figures montrent que ces brides 19 sont obtenues directement lors des opérations de découpage et de pliage du couvercle 5. Elles sont utilisées pour le maintien en place de la pile dans le mouvement, particulièrement lorsque le fond de la montre n'est pas encore mis en place, c'est-à-dire pendant les opérations de manutention du calibre nu. En plus de leur fonction mécanique, elles assurent la mise à la masse électrique de l'électrode de masse de la pile.

Différents procédés peuvent être utilisés pour assujettir le couvercle 5 au rebord 6. Le couvercle peut être soudé ou collé ou encore serti sur son appui.

Si l'on revient maintenant à la figure 2, on comprendra les avantages apportés par la présente invention. On s'aperçoit en effet que le logement de pile peut s'accommoder de piles dont la hauteur est comprise dans de larges tolérances sans qu'il soit nécessaire de changer le couvercle 5. Dans le cas où la pile est de faible hauteur la bride 19 appuyera sur l'arrondi supérieur de la pile comme cela est représenté au dessin ; dans le cas où cette hauteur est grande, la même bride appuyera sur le côté latéral de ladite pile. On voit également qu'il ne peut y avoir court-circuit si la pile est introduite à l'envers, du moins tant que le fond 3 n'est pas posé sur la boîte de montre. Enfin, l'absence de rebords en biseau, comme c'était le cas de la construction décrite lors de l'introduction de cette description, permet d'utiliser des piles de diamètres compris dans de larges tolérances, le pôle de l'électrode 9 reposant toujours sur le couvercle ce qui assure un encombrement constant en hauteur.

On s'aperçoit que la construction proposée prend très peu de place dans l'épaisseur de la platine. Le couvercle en effet est réalisé en matériau mince (environ 0,08 mm) ce qui est avantageux par rapport à la disposition où le fond du logement de pile fait partie intégrante de la platine. Comme ce couvercle est réalisé en matériau élastique (bronze au béryllium par exemple) on en profite pour lever la languette d'appui de pile. Ce couvercle, en fait, a un double rôle : celui d'appui mécanique de pile et celui de prise de contact électrique avec l'électrode de pile par l'intermédiaire du circuit imprimé.

**Revendications**

1. Logement de pile pour une montre électronique du type comportant une platine (1) située entre un fond (3) et un cadran (2), un circuit imprimé (11) comprenant un substrat isolant (12) et au moins une piste conductrice (13), ledit logement comportant un trou (4) traversant de part en part ladite platine, le bord du trou situé du côté cadran étant muni d'un rebord (6) faisant saillie dans le trou, caractérisé par le fait que le trou est obturé par un couvercle (5) réalisé en matériau élastique, ledit couvercle comportant des zones périphériques (7) venant s'appuyer et se fixer contre la face située du côté fond dudit rebord, une languette (8) étant levée dans ledit couvercle pour servir d'appui à une face (9) de la pile, la prise de contact électrique avec ladite face étant réalisée par le circuit imprimé intercalé entre ladite languette et ladite pile.

2. Logement de pile selon la revendication 1, caractérisé par le fait que le couvercle (5) est soudé contre la face située du côté fond dudit rebord.

3. Logement de pile, selon la revendication 1, caractérisé par le fait que le couvercle (5) est serti sur la face située du côté fond dudit rebord.

4. Logement de pile selon la revendication 1, caractérisé par le fait que le couvercle (5) est collé contre la face située du côté fond dudit rebord.

5. Logement de pile selon la revendication 1, caractérisé par le fait que le couvercle (5) comporte en outre au moins une bride (19) remontant le trou dans sa périphérie pour retenir la pile latéralement.

## Claims

1. A battery housing for an electronic watch of the type including a base plate (1) located between a back cover (3) and a dial (2), a printed circuit (11) comprising an insulating substrate (12) and at least one conductive track (13), said housing including a hole (4) entirely piercing said base plate, the rim of the hole located on the dial side being provided with a flange (6) projecting into the hole, characterized by the fact that the hole is obturated by a cover (5) formed from an elastic material, said cover comprising peripheric areas leaning upon and fixed to the face located at bottom of said flange, a tongue (8) being raised in said cover to serve as a support to one face (9) of the battery, the electrical contact with said face being obtained by the printed circuit inserted between said tongue and said battery.

2. A battery housing according to claim 1, characterized by the fact that the cover (5) is welded onto the face located at bottom of said flange.

3. A battery housing according to claim 1, characterized by the fact that the cover (5) is set onto the face located at bottom of said flange.

4. A battery housing according to claim 1, characterized by the fact that the cover (5) is glued onto the face located at bottom of said flange.

5. A battery housing according to claim 1, characterized by the fact that the cover (5) further comprises at least one clamp (19) rising through the hole at the periphery thereof for retaining the battery laterally.

**Patentansprüche**

1. Batteriekammer für eine elektronische Uhr, mit einer Platine (1), die zwischen einem Boden (3) und einem Zifferblatt (2) angeordnet ist, mit einer gedruckten Schaltung (11), die ein isolierendes Substrat (12) aufweist sowie wenigstens einen Leiter (13), wobei die Kammer eine Öffnung (4) umfaßt, die in der Platine vorgesehen ist und deren dem Zifferblatt benachbarter Rand mit einer in die Öffnung vorspringenden Kante (6) versehen ist, dadurch gekennzeichnet, daß die Öffnung durch einen aus elastischem Material bestehenden Deckel (5) verschlossen ist, der Umfangsbereiche (7) aufweist, die sich auf der dem Boden zugewandten Seite der Kante abstützen und dort festgehalten werden, wobei eine Lasche (8) in die Öffnung ragt, die als Auflage dient für eine Fläche (9) der Batterie und wobei der elektrische Kontakt mit dieser Fläche durch die gedruckte Schaltung erfolgt, die zwischen der Lasche und der Batterie angeordnet ist.

2. Batteriekammer nach Anspruch 1, dadurch gekennzeichnet, daß der Deckel (5) auf der dem Boden zugewandten Seite der Kante angeschweißt ist.

3. Batteriekammer nach Anspruch 1, dadurch gekennzeichnet, daß der Deckel (5) auf der dem Boden zugewandten Seite der Kante eingeklemmt ist.

4. Batteriekammer nach Anspruch 1, dadurch gekennzeichnet, daß der Deckel (5) auf der dem Boden zugewandten Seite der Kante aufgeklebt ist.

5. Batteriekammer nach Anspruch 1, dadurch gekennzeichnet, daß der Deckel (5) außerdem wenigstens einen Flansch (19) aufweist, der sich entlang des Umfangs der Öffnung erstreckt, um die Batterie seitlich zu halten.

Fig.1

Fig. 2

EP 0 209 717 B1